(19) Europäisches Patentamt
European Patent Office
Office européen des brevets

(11) Publication number: **0 291 537 B1**

(12) **EUROPEAN PATENT SPECIFICATION**

(45) Date of publication of patent specification: **08.09.93**

(51) Int. Cl.5: **G03C 1/00**, G03C 1/72, G03C 5/08, G03F 3/10, B44C 1/17

(21) Application number: **87907818.6**

(22) Date of filing: **26.11.87**

(86) International application number: **PCT/JP87/00916**

(87) International publication number: **WO 88/04068 (02.06.88 88/12)**

# (54) COLORED IMAGE-FORMING MATERIAL AND PROCESS FOR FORMING COLORED IMAGE.

(30) Priority: **26.11.86 JP 281443/86**
**01.10.87 JP 248564/87**
**16.10.87 JP 261129/87**

(43) Date of publication of application: **23.11.88 Bulletin 88/47**

(45) Publication of the grant of the patent: **08.09.93 Bulletin 93/36**

(84) Designated Contracting States: **DE FR GB IT NL**

(56) References cited:
**EP-A- 0 184 044**
**EP-A- 0 212 440**
**DE-A- 1 912 864**
**FR-A- 2 549 976**
**JP-A- 6 028 649**
**JP-A-61 286 850**
**JP-A-62 103 636**

**CHEMICAL ABSTRACTS, vol. 76, no. 14, 03 April 1972 Columbus, Ohio, USA An.: "Entrely new resin,Arkon, Its properties and applications." page 21; ref. no. 73080E**

(73) Proprietor: **MITSUBISHI KASEI CORPORATION**
**5-2, Marunouchi 2-chome Chiyoda-ku**
**Tokyo 100(JP)**

Proprietor: **KONICA CORPORATION**
**26-2, Nishishinjuku 1-chome, Shinjuku-ku**
**Tokyo 160(JP)**

(72) Inventor: **IDE, Hiroshi**
**17-2-10, Nishihashimoto 1-chome**
**Sagamihara-shi**
**Kanagawa-ken 229(JP)**
Inventor: **MAYAMA, Shinya**
**23-4, Tanacho, Midori-ku Yokohama-shi**
**Kanagawa-ken 227(JP)**
Inventor: **MASUDA, Tetsuya**
**6-3, Tachibanadai 2-chome Midori-ku**
**Yokohama-shi Kanagawa-ken 227(JP)**
Inventor: **SASA, Nobumasa**
**27-5, Sayama, Sayama-shi**
**Saitama-ken 350-13(JP)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.6/3.3.1)

PATENT ABSTRACTS OF JAPAN vol. 5, no. 32 (P-50)(704) 27 February 1981

Inventor: **WATANABE, Manabu**
**5-19, Owadamachi 2-chome Hachioji-shi**
**Tokyo 192(JP)**
Inventor: **SHIMIZU, Kunio**
**1271-15, Hanasaki Otsukimachi, Otsuki-shi**
**Yamanashi-ken 401(JP)**

(74) Representative: **Woods, Geoffrey Corlett et al**
**J.A. KEMP & CO. 14 South Square Gray's Inn**
**London WC1R 5EU (GB)**

## Description

The present invention relates to a coloured image forming material and a method for forming a coloured image. More particularly, the present invention relates to a coloured image forming material and a method for forming a coloured image which are suitable for colour proofing in colour printing.

In current printing methods, whether by planography, letterpress or gravure, the printing image of a design or photograph is composed of thousands of half tone dots. Particularly in case of the colour printing, since the image is reproduced mainly by using printing inks of four different colours, i.e., black, cyan, magenta and yellow, printing plates for each colour are prepared. The preparation of these printing plates necessitates halftone positive films or halftone negative films for each colour, which are obtained by colour separation of the original colour image.

The correction of halftone films is usually performed by the proof printing method, wherein the defects of halftone films requiring correction are examined by preparing printing plates for each colour from the corresponding half tone film and reproducing the colour image using the printing plates mounted on a printing machine. However, such a process does not result in stable quality because a number of variable factors such as the ink/water balance and the amount of the ink are involved. This process has another disadvantage in that it is time consuming. It is therefore desirable to provide a convenient means for reproducing a coloured image from a half tone film.

To solve the above problem, various relatively convenient methods for reproducing a coloured image (colour proofing systems) have been proposed. Examples of those methods include a method wherein a multicoloured image is reproduced by the adhesion of colour toners caused by photovariable adhesion and a method wherein a multicoloured image is reproduced by exposing imagewise photosensitive colour films, treating them with a developing solution and laminating the thus obtained coloured images successively on an image receptive element.

Particularly in the methods disclosed in JP-B-49-441, JP-A-47-41830 and JP-A-60-28649, which belong to the latter method mentioned above, a coloured image is transferred onto an image receptive material by placing the image recieving material on the surface of the image formed on an image forming material which comprises an intermediate hot melt adhesive layer consisting of a film-forming thermoplastic resin thermally adhesive at a temperature of 60 °C to 130 °C between a coloured image recording layer and a substrate, and pressing them under heating to bond the hot melt adhesive layer together with the coloured image onto the image receptive material.

However, since this image forming material is produced by coating a coloured image recording layer containing a colouring agent directly on the hot melt adhesive layer, when the hot melt adhesive layer is composed of a known thermoplastic resin, it has a disadvantage that it is apt to contaminate the non-image area (scumming) after the development due to the colouration of the surface of the hot melt adhesive layer, which is caused by the fusion or swelling of the hot melt adhesive layer upon lamination.

If the softening point of the hot melt adhesive layer alone is lowered to facilitate the transfer of the coloured image onto the image receptive paper, the image forming material eventually sustains cracks due to the difference of the thermal expansion coefficients of the hot melt adhesive layer and the coloured image recording layer which are adjacent each other, and accordingly the thermal stability of the material during aging is deteriorated. To eliminate this disadvantage, a coloured image recording layer may also consist of a thermoplastic polymer, but such an image recording layer generally cannot be developed with an alkaline aqueous solution and it inevitably requires an organic solvent for the development. It is not preferred for reasons of sanitation of the working environment.

Furthermore, when the coloured image forming materal is imagewise exposed to light on the side of coloured image recording layer, as conventionally practiced, a relatively high energy of active light is needed to clearly define the boundary between the exposed area and non-exposed area since the colouring agent contained in the coloured image recording layer absorbs the light during the exposure. That is, the colour image forming material has a low sensitivity such that it is difficult to distinctly form small half tone dots and fine lines. Moreover, this process has another disadvantage in that the transferred image is reverse to the original image, because the image forming material is exposed to the light on the side of the coloured image recording layer.

Chemical Abstracts 76:73080e (1972) discloses Arkon, a saturated alicyclic hydrocarbon resin. Arkon is used as a tackifier for pressure-sensitive adhesive tapes.

DE-A-1,912,864 discloses various resins for use in the hot melt adhesive layer. EP-A-184,044 discloses image recording layers containing a polymer comprising units of formula:

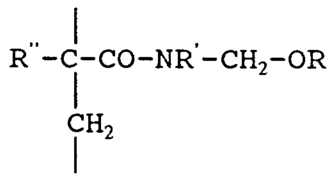

wherein R' is hydrogen or an alkyl group, R'' is hydrogen or a methyl group and R is hydrogen or an alkyl, acyl or hydroxyalkyl group.

Patents Abstract of Japan, 5, 32(P-50)[704](JP-A-54-63697) discloses a printing plate comprising a photosensitive composition consisting of a high molecular weight compound containing monomer units having an aromatic hydroxyl group and (methyl)acrylic acid ester monomer units.

EP-A-212,440, published between the first and second priority dates of the present invention, discloses a printing plate which contains a polymer comprising units of formula:

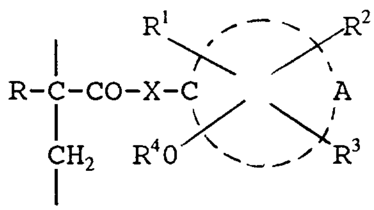

wherein R is hydrogen, a halogen or a cyanide or $C_{1-4}$ alkyl group, $R^1$, $R^2$, $R^3$ and $R^4$ are various substituents, X is, inter alia, $NR^8$ ($R^8$ is hydrogen or an alkyl or aryl group) and A completes a mononuclear or dinuclear aromatic ring system.

The present invention seeks to provide a coloured image forming material and a method for forming a coloured image, which can eliminate the above mentioned drawbacks of the conventional coloured image forming material comprising a hot melt adhesive layer and coloured image recording layer successively laminated on a transparent substrate and which can enable a coloured image of good quality comparable to printed matter to be easily obtained.

The present invention provides a coloured image forming material comprising a transparent substrate having successively formed thereon a hot melt adhesive layer and a coloured image recording layer containing a photosensitive composition, characterised in that the hot melt adhesive layer contains a resin polymer having saturated alicyclic hydrocarbon groups.

The coloured image recording layer may, for example, contain a polymer comprising structural units of formula (I):

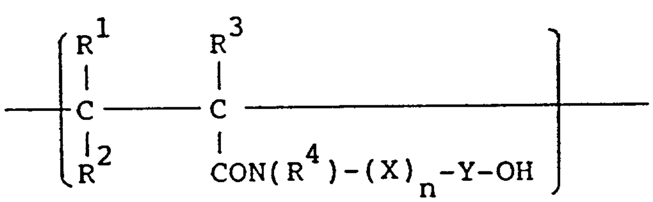

wherein:
$R^1$ and $R^2$ independently represent hydrogen, an alkyl group or a carboxylic acid group,
$R^3$ represents hydrogen, a halogen or an alkyl group;
$R^4$ represents hydrogen, an alkyl group, a phenyl group or an aralkyl group,
Y represents an optionally substituted phenylene group or an optionally substituted naphthylene group,
X represents a divalent organic group connected to a carbon atom of the aromatic ring of the Y group, and
n is 0 or 1.

The present invention also provides a method for forming a coloured image which comprises imagewise exposing a coloured image forming material as defined above to actinic radiation, developing the exposed material to form a coloured image and transferring the formed image onto a receptive surface of a receptive

material.

The imagewise exposure of the material to the actinic radiation may be effected on, for example, the side of the transparent substrate.

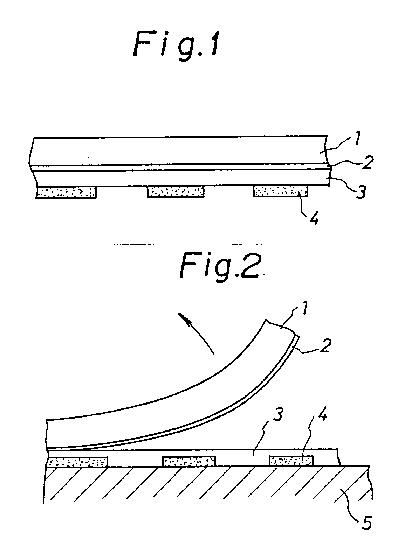

Fig. 1 is a cross-sectional view of an example of coloured image film obtained by imagewise exposing the coloured image forming material of the invention to actinic rays and developing it, and Fig. 2 is an illustrative sectional view of the material after the heat treansfer of the image onto the image receptive material.

In the drawings, 1 is a transparent substrate, 2 is a release layer, 3 is a hot melt adhesive layer, 4 is an image composed of the residual portion of the image recording layer and 5 is an image receptive material.

The material for the transparent substrate of the coloured image forming material according to the invention is not restricted to any specific material. However, the transparent substrate is preferably composed of a polyester film, particularly a biaxially oriented polyethylene terephthalate film from the viewpoint of the dimensional stability thereof against moisture and heat. The transparent substrate may also be composed of, for example, an acetate film, polyvinyl chloride film, polystyrene film, polypropylene film or polyethylene film.

The transparent substrate is preferably subjected to a release treatment to enhance the transferability of the image and hot melt adhesive layer onto the image receptive material. The release treatment is, for example, effected by depositing a suitable volatile material such as a silicone resin, fluorocarbon resin or fluoride type surfactant by means of, for example, simple application, or by laminating a release layer of, for example, an alcohol-soluble polyamide, alcohol-soluble nylon, a partially esterified styrene/maleic anhydride copolymer or polyvinyl alcohol in a thickness of about 1 $\mu$m on the surface of the substrate.

The hot melt adhesive layer to be laminated on the transparent substrate is preferably transparent, and is preferably fusible and bondable at a temperature of from 70°C to 150 °C and not adhesive at room temperature.

The hot melt adhesive layer is preferably made from a resin polymer containing saturated alicyclic hydrocarbon groups, i.e., groups containing a carbon atom ring free of unsaturated bonds to prevent scumming by colouration in the non-image area after the developing treatment and to enhance the thermal transferability of the image.

The resin polymer containing saturated alicyclic hydrocarbon groups can be obtained, for example, by the hydrogenation of aromatic hydrocarbon groups contained in a petroleum resin in a conventional manner. The proportion of hydrogenation is preferably 80 to 100 %, particularly 95 to 100 %, of the whole resin.

The weight average molecular weight of the resin polymer containing saturated alicyclic hydrocarbon groups is preferably from 500 to 1000, particularly from 500 to 900, from the viewpoint of thermal transferability. The softening point of the resin polymer containing saturated alicyclic hydrocarbon groups is preferably from 70°C to 150°C, particularly from 70°C to 120°C, from the viewpoint of the dimentional thermostability of the image receptive material during the transfer.

Examples of the resin polymer containing saturated alicyclic hydrocarbon groups include the products commercially available from Arakawa Chemical industry Co.,Ltd. under the Arkon P series and M series marks.

The hot melt adhesive layer may comprise other known thermoplastic resins having a softening point of from 70°C to 140°C such as an olefin (co)polymer, vinyl chloride (co)polymer, vinylidene chloride (co)-polymer, vinyl acetate (co)polymer, ketone resin, styrene/acrylate (co)polymer or styrene/butadiene rubber. The hot melt adhesive layer preferably contains from 10 to 100 % by weight, particularly from 50 to 95 % by weight, of the resin having saturated alicyclic hydrocarbon groups.

The thickness of the hot melt adhesive layer is preferably 1 to 20 $\mu$m, particularly 2 to 10 $\mu$m. In order to obtain an uniform transferred image of high quality, the thickness of the hot melt adhesive layer should be equal to or greater than the thickness of the image recording layer which will be described hereinafter.

The coloured image recording layer containing a photosensitive composition is laminated on the hot melt adhesive layer.

Any material suitable for the purpose can be used for the coloured image recording layer, that is, any material which can form a coloured image by imagewise exposure to actinic light and subsequent development. It is generally mainly composed of a binder and a colouring agent as well as the photosensitive composition.

As the photosensitive composition, both positive and negative types may be used. Examples of the positive type include quinonediazide compounds and the photosensitive compositions of the acid dissociation type as disclosed in JP-A-61-134536. The quinonediadide compounds suitably used for the invention include the condensate compounds of 1,2-benzoquinonediazide-4-sulfonyl chloride, 1,2-naphthoquinonediazide-4-sulfonyl chloride, 1,2-naphthoquinonediazide-5-sulfonyl chloride or 1,2-naphthoquinonediazide-6-sulfonyl chloride with a compound containing one or more hydroxyl groups and/or amino groups.

Examples of the compound containing one or more hydroxyl groups include trihydroxybenzophenone, dihydroxyanthraquinone, bisphenol A, phenolic novolak resin, resorcin/benzaldehyde condensate resin and pyrogallol/acetone condensate resin. Examples of the compound containing one or more amino groups include aniline, p-aminodiphenylamine, p-aminobenzophenone, 4,4'-diaminodiphenylamine and 4,4'-diaminobenzophenone.

Further information concerning quinonediazide compounds including those described herein is given in J. Kosar, "Light Sensitive System", Wiley & Sons, New York, 1965 and Nagamatsu and Inui, "Light Sensitive Polymer", Kodansha, 1977.

The photosensitive compositions suitable for a coloured image recording layer of negative type include photosensitive resins of photocross-linking type, of which typical examples are polyvinyl alcohol esterified with cinnamic acid, diazonium salts and the condensates thereof and aromatic azide compounds. Photosensitive compositions utilizing radical photopolymerization and ionic photopolymerization may be also.

As the binder used in the coloured image recording layer, a film-forming polymer which is soluble in a solvent and soluble or swellable in the developing solution may be used. When the softening point of the polymer is significantly lower than that of the thermoplastic resin used in the hot melt adhesive layer described hereinbefore, a deformed transferred image may be obtained due to the deformation of the formed image during the transfer onto the image receptive material by heating and pressing. Accordingly, the polymer preferably has a softening point higher than 70 ° C.

As such a binder, a polymer containing structural units of formula (I) as defined above, having an aromatic hydroxyl group in the molecular structure is preferably used.

Examples of a monomer forming the structural unit of formula (I) include (meth)acrylamide monomers such as N-(4-hydroxyphenyl)-(meth)acrylamide, N-(2-hydroxyphenyl)-(meth)acrylamide, N-(4-hydroxynaphtyl)-(meth)acrylamide; o-, m-or p-hydroxyphenyl (meth)acrylate monomers; and o-, m- or p-hydroxystyrene monomers. Preferred monomers are o-, m- or p-hydroxyphenyl (meth)acrylate monomers and N-(4-hydroxyphenyl)-(meth)acrylamide monomers. The most preferred monomer is N-(4-hydroxyphenyl)-(meth)-acrylamide monomer.

According to the invention, it is preferred to use a copolymer of the monomer forming the structural units of formula (I) with monomers such as;
acrylonitriles;

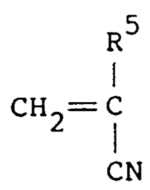

alkyl acrylates;

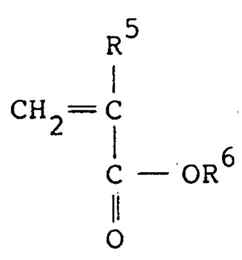

and acrylic acids;

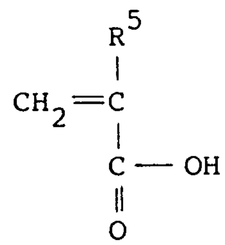

wherein $R^5$ represents hydrogen, an alkyl group or a halogen and $R^6$ represents an alkyl group, a phenyl group or a naphthyl group.

The polymer preferably contains 1 to 30 molar % of units of formula (I) so that the material can be developed in a weakly alkaline aqueous solution having a pH of 8 to 11, for example an aqueous solution of sodium carbonate, and more preferably contains 1 to 25 molar % in order to prevent cracks in the coloured image forming material by adjusting the softening point of the coloured image recording layer to from 50 ° C to 150 ° C.

The polymer preferably contains 0 to 50 molar % of units formed from the abovementioned acrylonitriles, and more preferably contains 5 to 40 molar % of the acrylonitriles from the viewpoint of developability. The content of the structural unit formed from the abovementioned alkyl acrylates is preferably 50 to 95 molar % in the polymer for development in a weakly alkaline aqueous solution. The best developability is obtainable with a 60 to 95 molar % alkyl acrylate content.

The polymer may be copolymerized with acrylic acids as mentioned above such as acrylic acid and methacrylic acid in order to finetune the developability. The acrylic acids content is preferably 0 to 20 molar %, most preferably 0 to 10 molar %, from the viewpoint of development latitude.

The weight average molecular weight of the polymer is preferably 1,000 to 100,000, more preferably 1,000 to 30,000 from the viewpoint of developability in a weakly alkaline aqueous solution and resolvability. The polymers can be prepared by any known copolymerization method.

Examples of the polymer include copolymers of the structure:

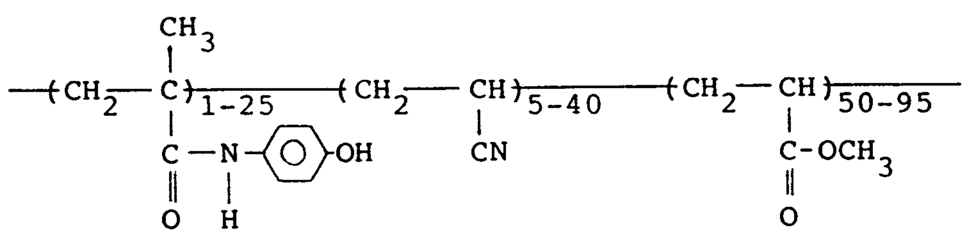

(weight average molecular weight of 1,000 to 30,000)

As the binder, a novolak resin prepared by the polycondensation of at least one phenolic compound and active carbonyl compound may be used in combination with the polymer containing units of formula (I).

Other polymers usable as the binder include, for example, sulfoalkyl esters of (meth)acryl acid (co)-polymer, vinyl acetal (co)polymer, vinyl ether (co)polymer, acrylamide (co)polymer, styrene (co)polymer and cellulose derivatives. The coloured image forming layer preferably contains 30 to 95 % by weight, more preferably 50 to 90 % by weight, of the binder.

As the colouring agent, dyes or pigments are incorporated in the image recording layer. Particularly, pigments or dyes having a yellow, magenta, cyan or black tint are required for the colour proofing process. However, metal powder, white pigment or fluorescent pigment may also, for example, be incorporated in the coloured image recording layer. Examples of pigments and dyes which can be used and which are well known in the field are: (The abbreviation C.I. means "Color Index")

Victria Pure Blue (C.I. 42595)
Auramine (C.I. 41000)
Catilon Brilliant Flavin (C.I. Basic 13)
Rhodamine 6 GCP (C.I. 45160)
Rhodamine B (C.I. 45170)

Safranine OK 70:100 (C.I. 50240)
Erioglaucine X (C.I. 42080)
Fast Black HB (C.I. 26150)
No. 1201 Lionol Yellow (C.I. 21090)
Lionol Yellow GRO (C.I. 21090)
Symuler Fast Yellow 8GF (C.I. 21105)
Benzidine Yellow 4T-564D (C.I. 21095)
Symuler Fast Red 4015 (C.I. 12355)
Lionol Red 7B 4401 (C.I. 15830)
Fastogen Blue TGR-L (C.I. 74160)
Lionol Blue SM (C.I. 26150)
Mitsubishi Carbon Black MA-100
Mitsubishi Carbon Black #30, #40, #50

The ratio of the amounts of the colouring agent and the binder contained in the coloured image recording layer can be determined by any method known to those skilled in the art in consideration of the specific optical transmission density desired and the removability of the coloured image recording layer in the developing solution. For example, the coloured image forming layer preferably contains 5 to 75 % by weight of a dye or dyes or 5 to 90 % by weight of a pigment or pigments. The coloured image recording layer preferably has at least 0.4 optical transmission density.

The thickness of the coloured image recording layer may be determined in consideration of the optical density desired, the content and the kind of the colouring agent (dye, pigment or carbon black) used in the coloured image recording layer according to any method known to those skilled in the art. However, a higher developability and quality of image can be obtained with a thinner image recording layer so long as it has an acceptable thickness. Accordingly, the thickness of the coloured image recording layer is preferably 1 to 10 $\mu$m, more preferably 1 to 4 $\mu$m.

The coloured image recording layer described above may contain various additives for different purposes.

For example, the coloured image recording layer may contain a surfactant such as cellulose, alkyl ether, fluoride type surfactant or a silicone compound to improve the applicability; an acid anhydride such as glutaric anhydride or phthalic anhydride to accelerate the development; and a plasticizer such as a phosphate ester or phthalate ester to improve the physical properties of the applied layer.

In the coloured image forming material, a part of the coloured image recording layer may be replaced with a colourless image recording layer which does not contain any colouring agent, i.e. a colourless image recording layer may be interposed between the coloured image recording layer and the hot melt adhesive layer. The colourless image recording layer generally has the same composition as the coloured image recording layer with the exception that it does not contain any colouring agent. The total thickness of the recording layer containing a colouring agent and the recording layer not containing any colouring agent is 1 to 10 $\mu$m, preferably 1 to 4 $\mu$m.

The coloured image forming material according to the invention can be produced from those materials described above; the process for the preparation thereof is not particularly limited. For example, the coloured image forming material of the invention can be produced by dissolving the aforementioned components of the hot melt adhesive layer in a suitable solvent, applying the solution on a transparent substrate, drying the applied layer and then applying a solution of the aforementioned components of the coloured image recording layer in a suitable solvent on the hot melt adhesive layer. Alternatively, the coloured image forming material of the invention can be produced by applying a solution of the components of the image recording layer not containing any colouring agent in a suitable solvent on the hot melt adhesive layer laminated on a substrate, drying the applied layer and then applying a solution of the aforementioned components of the coloured image recording layer in a suitable solvent on the colourless image recording layer.

Examples of the solvent which can be used include water, methanol, ethanol, acetone, ethyl acetate, methyl cellosolve, ethyl cellosolve, dioxane, methyl ethyl ketone, cyclohexane, diethyleneglycol monomethyl ether, gamma-butyrolactone, tetrahydrofuran, methylene chloride, ethylene chloride, dimethyl sulfoxide and dimethyl formamide. They can be used as a pure liquid or as a mixture thereof.

An example of a method for forming a coloured image utilizing the coloured image forming material of the invention produced as above is now described.

Firstly, the coloured image forming material is superposed with a positive or negative colour separation mask and radiated with actinic radiation for imagewise exposure of the material. The colour separation mask is preferably superposed on the side of the transparent substrate.

Various light sources such as an ultra-high pressure mercury lamp, tungsten lamp, mercury lamp, xenone lamp, fluorescent lamp, CRT light source or laser light source may be used for the imagewise exposure.

The image forming material thus exposed is then treated with a solution which can dissolve the non-image portion of the image recording layer and which cannot dissolve the image portion of the image recording layer to eliminate the non-image portion, to obtain the coloured image.

For the development of the recording layer described above, it is important to select a solution suitable for the specific image recording layer. This selection can be effected according to any conventional technique.

Particularly, the coloured image recording layer containing a polymer having structural units of formula (I) can be developed with a weakly alkaline aqueous solution instead of an organic solvent. The preferred developer is an aqueous solution having a pH of 8 to 11, for example an aqueous solution of sodium carbonate, sodium hydrogencarbonate or sodium silicate.

After the imagewise exposure and the development described above, a coloured image film, of which an example is illustrated in Fig. 1, can be obtained. 1 is a transparent substrate, 2 is a release layer, 3 is a hot melt adhesive layer and 4 is an image portion which is a residual portion of the image recording layer after development.

The coloured image thus obtained is transferred onto an image receptive material. This transfer is effected by contacting the surfaces of the image recording layer and the image receptive material 5 as illustrated in Fig. 2 and passing the combination through a laminator under heating and pressing. In the laminator the heating temperature is preferably from 70 to 150 °C and the passing speed is preferably from 50 to 100 cm/min. As a result of such heating and pressing during the passage through the laminator, the hot melt adhesive layer 3 applied between the image recording layer and the substrate 1 is melted and bonded onto the surface of the image receptive material 5. During the transfer, the image portions 4 are transferred and laminated on the surface of the image receptive material 5 while they are contained in the hot melt adhesive layer 3.

Examples of the image receptive material include papers such as wood free paper, art paper and coated paper; plastic films such as polyester film, acetate film and polypropyrene film; metal foils such as aluminium foil and copper foil; and composite materials thereof.

A multi-colour proofing sheet can be produced by repeating the transfer and lamination of each exposed and developed colour image recording layer onto the already transferred and laminated image in the same manner described above.

In the above described method for forming a coloured image, the exposure is preferably effected on the side of the transparent substrate contrary to the conventional method. This makes it possible to obtain a normal transferred image relative to the original image and also to render the method more sensitive than the conventional method because actinic radiation with a smaller energy than has been conventionally required can reach to the interface between the hot melt adhesive layer and the coloured image recording layer. For example, it was found that the method according to the invention requires only one half to one sixth of the exposure as compared with the conventional method when the coloured image recording layer contains a quinonediazide compound.

Since the exposure is effected on the side of the transparent substrate, the actinic radiation inevitably passes thorough the transparent substrate and the hot melt adhesive layer. In order to compensate for the diminution of the resolving power due to the passage, the coloured image forming material may contain a contrast enhanced layer (hereinafter referred to as "CE layer"). This CE layer is more advantageously interposed between the hot melt adhesive layer and the coloured image recording layer than between the transparent substrate and the hot melt adhesive layer.

Examples of the compound suitable for use in the CE layer include ultra violet ray absorbents such as p-t-butylphenyl salicylate, 2-hydroxy-4-methoxybenzophenone and 2'-(2'-hydroxy-5-methoxyphenyl)-benzotriazole; photobleachable coloring matters; nitron; polysilanes; and diazonium salts. The thickness of the CE layer is preferably from 0.1 to 10 μm, more preferably from 0.2 to 4 μm.

## Examples

The present invention is now further described in the following Examples and Comparisons.

Wherever the term "parts" is mentioned, it is meant as "parts by weight".

Example 1:

On a biaxially oriented polyethylene terephthalate film of 75 µm thickness, a solution of a polymer composition formulated as shown below was applied by means of a wire bar. The applied layer was dried at 60 °C for 5 minutes to produce a hot melt adhesive layer of 7 µm thickness.

| | |
|---|---|
| Arkon P-90 (Resin having saturated alicyclic hydrocarbon groups, Arakawa Chemical Industry Co.,Ltd.) | 60 parts |
| Arkon P-100 (Resin having saturated alicyclic hydrocarbon groups, Arakawa Chemical Industry Co.,Ltd.) | 15 parts |
| Toughprene A (Styrene/butadiene copolymer, Asahi Chemical Industries Co.,Ltd.) | 25 parts |
| Toluene | 75 parts |

An alkali-soluble polymer composition is prepared according to the following procedure.

In a four-neck flask having an inner volume of 1 liter, 8.85 g of hydroxyphenylmethacrylamide, 2.65 g of acrylonitrile, 33.11 g of methyl acrylate and 1.64 g of azobisisobutylonitrile (polymerization initiator) were heated and reacted at 77 °C for 6 hours in a 200 g ethyl alcohol solvent. The reaction was stopped by adding 75 g of methyl cellosolve and ethyl alcohol was distilled off by heating at 60 °C for 3 hours to obtain about 95 g of a polymer represented by the following formula:

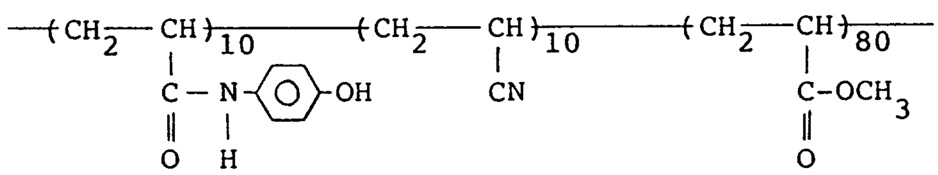

as a 50 % solution in methyl cellosolve.

The weight average molecular weight of the polymer was 17,000 according to analysis by gel permeation chromatography. All of the weight average molecular weights mentioned hereinafter were determined by the same method.

A photosensitive solution of the following composition was prepared by utilizing the resultant polymer solution, applied on the hot melt adhesive layer by means of a wire bar and then dried at 60 °C for 5 minutes to produce a coloured image recording layer of 1.5 µm thickness.

| | |
|---|---|
| Polymer solution (50%) | 66.2 parts |
| Photosensitive material 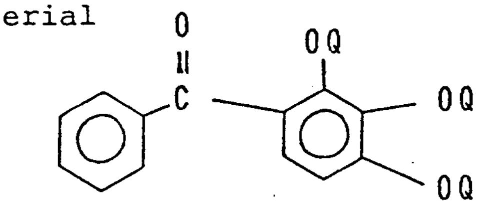 | 8.4 parts |
| wherein Q represents 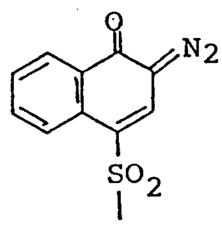 | |
| Pigment: Cyanine Blue 4927 (Dainichiseika Color & Chemicals Mfg Co.,Ltd.) | 4.6 parts |
| Methyl cellosolve | 273 parts |

The coloured image forming material thus obtained was exposed on the side of the polyethylene terephthalate film by means of an 1-kW metal halide lamp light source for 10 seconds and developed in a developing solution prepared by dissolving sodium carbonate in 1 liter of water at 25 °C and adjusting the pH to 9. As a result, an image of high quality was obtained, that is, the image forming material could be developed in a weakly alkaline aqueous solution. When the coloured image forming material was placed in an air-conditioned room at 55 °C to examine the preservability thereof, no cracks were observed, regardless of the humidity.

By contacting thus obtained image with a sheet of image receptive paper and transferring by a laminator under the conditions of 110 °C, 70cm/min and 5kg/cm$^2$, an image of high quality comparable to printed matter was obtained on the receptive paper.

For comparision, a coloured image forming material was produced by following the procedure described above, except that a photosensitive solution of the following composition was used.

| | |
|---|---|
| Meta-cresol novolak resin (weight average molecular weight of 2600) | 41.6 parts |
| Photosensitive material (the same compound as used above) | 5.9 parts |
| Pigment: Cyanine Blue 4927 (Dainichiseika Color & Chemicals Co.,Ltd.) | 5.3 parts |
| Methyl cellosolve | 324.9 parts |

This coloured image forming material was exposed and developed by following the procedures described above. However, it could not be developed in the same developing solution no matter how much the degree of exposure was varied.

Furthermore, during the analysis of its preservability in the air-conditioned room, a considerable number of cracks were found within 12 hours and they were found throughout the entire surface within 2 days. The results indicate that this comparison material has a poorer preservability than the aforementioned material of the invention.

Example 2:

A coloured image forming material of the negative type was produced by applying a photosensitive solution of the following composition by means of a wire bar on a hot melt adhesive layer prepared in the same manner as described in Example 1.

| | | |
|---|---|---|
| Diazo resin of the formula (weight average molecular weight of about 1000) | 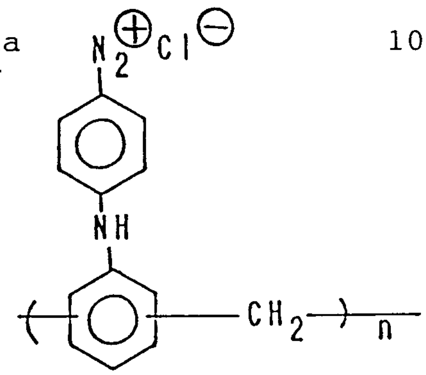 | 10 parts |
| Polymer solution (the same as in Example 1) | | 100 parts |
| Polyacrylic acid: Jurymer AC10L (Nihon Junyaku Co.,Ltd.) | | 3 parts |
| Victria Pure Blue BOH (Hodogaya Chemical Co.,Ltd.) | | 2 parts |
| Methyl Cellosolve | | 1800 parts |

After exposure and development in the same manner as indicated in Example 1 except that the degree of exposure was varied, an excellent image was obtained without any cracks on its surface.

By transferring the coloured image in the same manner as indicated in Example 1, a transferred image of high quality comparable to printed matter was obtained on the receptive paper.

Example 3:

On a biaxially oriented polyethylene terephthalate film of 75 µm thickness, a coating solution of following composition was applied by means of a wire bar to form a release layer of 0.5 µm thickness.

| | |
|---|---|
| Alcohol-soluble polyamide (CM-8000, Toray Industries, Inc.) | 7.2 parts |
| Polyhydroxystyrene (Resin M, Maruzen Petrochemical Co.,Ltd, weight average molecular weight of 5500) | 1.8 parts |
| Methanol | 400 parts |
| Methyl cellosolve | 100 parts |

A coloured image recording layer was laminated by applying the same composition as used in Example 1 and drying the applied layer. After exposure to actinic radiation from a 1-kW metal halide lamp for 30 seconds and development effected in the same manner as in Example 1, an excellent image was obtained.

The thus obtained image was then transferred by heating and pressing by means of a laminator under the conditions of 80 °C, 70 cm/min and 5 kg/cm$^2$ onto an image receptive material prepared by applying an image receptive layer (28 µm of thickness) having the following composition on a biaxially oriented polyethylene terephthalate film of 100 µm thickness.

| | |
|---|---|
| Vinyl chloride/vinyl acetate/vinyl alcohol copolymer (S-Lec A, Sekisui Chemical Co.,Ltd) | 90 parts |
| Pentaerythritol tertraacrylate | 54 parts |
| Michler's ketone | 0.51 parts |
| Benzophenone | 3.18 parts |
| Para-methoxyphenol | 0.09 parts |
| Methyl ethyl ketone | 220 parts |

The image surface was contacted with a sheet of image receptive paper and the image was transferred again on the image receptive paper by means of a laminator under the conditions of 120 °C, 70 cm/min and 5 kg/cm$^2$ of the transfer pressure. After exfoliation of the polyethylene terephthalate layer, an excellent normal image was obtained on the receptive paper.

Example 4:

A biaxially oriented polyethylene terephthalate film of 75 um thickness, which had been coated with a release layer, was applied with a solution of 75 parts of a resin having a softening point of 90 °C and containing saturated alicyclic hydrocarbon groups (Arkon P-90, Arakawa Chemical Industry Co.,Ltd.) and 25 parts of styrene/butadiene copolymer (Toughprene A, Asahi Cemical industries Co.,Ltd.) in toluene on the release layer by means of a wire bar and dried with a hot air blow at 60 °C for 5 minutes to produce a hot melt adhesive layer of 7 µm thickness. Then, the hot melt adhesive layer was applied with a photosensitive composition of positive type having the following composition by means of a wire bar and dried with a hot air blow at 60 °C for 5 minutes to form a coloured image recording layer of 1.5 µm thickness.

| | |
|---|---|
| Phenol-cresol(2:3 in molar ratio)/ formaldehyde novolak resin (weight average molecular weight of 10000) | 90 parts |
| Ortho-thioformate ester polymer of the formula; | 15 parts |

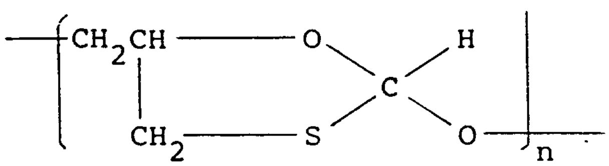

(weight average molecular weight of about 1000)

| | |
|---|---|
| 2-trichloromethyl-5-(beta-(2-benzofuryl) -vinyl)-1,3,4-oxadiazole | 3 parts |
| Cyanine Blue 4927 (Dainichiseika Color & Chemicals Mfg Co.,Ltd.) | 5 parts |
| Ethyl Cellosolve | 550 parts |

The high-sensitive coloured image forming material of positive type obtained above was closely contacted with a colour separation halftone positive film having on its surface a polyethylene terephthalate layer and exposed to light of 50 mJ/cm$^2$ from a high-pressure mercury lamp. Then, the coloured image forming material was developed by dipping it in a 1 % aqueous solution of sodium silicate for one minute at 25 °C to give an excellent blue coloured image.

The thus obtained blue coloured image film was superposed on a coated paper by contacting the surface of the coloured image recording layer with a sheet of the coated paper, and passed through a laminator under the conditions of a roller temperature of 130 °C and a laminating speed of 60 cm/min. After cooling to room temperature, the polyethylene terephthalate layer was peeled off from the laminated material. As a result, the blue coloured image formed on the film, including minute image portions to large image portions, was completely transferred onto the surface of the coated paper without any residual image portion on the film.

The non-image area of the transferred image perfectly reproduced the tint of the image receptive material. Thus, a blue coloured image of high quality comparable to printed matter was obtained.

Example 5:

A polyethylene terephthalate film having a release layer was coated with a solution of the following composition in a thickness 7 µm to obtain a support having a hot melt adhesive layer.

| | |
|---|---|
| Resin having saturated alicyclic hydrocarbon groups (Arkon P-100, Arakawa Chemical Industry Co.,Ltd.) | 80 parts |
| Styrene/butadiene copolymer resin (Toughprene A, Asahi Chemical Industries Ltd.) | 20 parts |
| Toluene | 300 parts |

Photosensitive solutions having the compositions represented in the Table below, which correspond to four colours, were prepared and applied on the support in a thickness of 1.5 µm.

Composition of Photosensitive Solutions

| | Black | Cyan | Magenta | Yellow |
|---|---|---|---|---|
| Benzyl methacrylate/methacrylic acid copolymer (molar ratio of 73:27) | 60 | 60 | 60 | 60 |
| Pentaerythritol tetraacrylate | 43.2 | 43.2 | 43.2 | 43.2 |
| Michler's ketone | 0.41 | 0.41 | 0.41 | 0.41 |
| Benzophenone | 2.54 | 2.54 | 2.54 | 2.54 |
| Para-methoxyphenol | 0.12 | 0.12 | 0.12 | 0.12 |
| Methyl cellosolve | 1000 | 1000 | 1000 | 1000 |
| Pigment | | | | |
| Carbon Black #50 (Mitsubishi Chemical Industries, Ltd.) | 19.8 | - | - | - |
| Chrome Phthal Blue 4GN (Ciba Geigy AG) | - | 11.0 | - | - |
| Chrome Phthal Red A (Ciba Geigy AG) | - | - | 13.6 | - |
| Chromophthal Yellow 8G (Ciba Geigy AG) | - | - | - | 13.6 |

On the coloured image recording layer, a solution having a composition shown below was further applied to form a overcoating layer of 0.3 µm dry thickness.

| | |
|---|---|
| Polyvinyl alcohol (GL-05, Nippon Synthetic Chemical Industries Co.,Ltd.) | 60 parts |
| Distilled water | 970 parts |
| Methanol | 30 parts |

The thus obtained coloured image forming materials having four colours were respectively superposed with a colour separation negative mask of each colour, exposed imagewisely to actinic radiation from a 3-kW metal halide lamp positioned at a distance of 50 cm and then developed by being immersed for 20 seconds at 35°C in a developing solution prepared by diluting SDN-21 (Sakura PS plate developer, Konica Corp.) to 3 times of the original volume, to give coloured images having four colours.

Then the black coloured image was contacted with a sheet of art paper and passed through a pair of nip rollers heated to 100°C to transfer the coloured image onto the art paper. Subsequently, the cyan, magenta and yellow colored images were successively transferred on the image receptive sheet to give a colour proofing sheet composed of the four colours.

The colour proof thus obtained was found to bear a perfectly transferred image with no scumming of the non-image area, and it was of excellent quality comparable to printed matter.

Comparison Examples 1 to 5

Various colour proofs were prepared in the same manner as indicated in Example 1, except that the resins disclosed in the Examples of JP-A-47-41830 were used as the hot melt adhesive layer.

The results are shown below.

| Hot melt adhesive layer | | Result (The images were transferred onto a sheet of art paper) |
|---|---|---|
| 1. | Shellac (Japan Shellc Co.,Ltd.) | The image was partially transferred on art paper. (Scumming of non-image area) |
| 2. | Cellulose acetate phthalate copolymer (Daihachi Kagaku Kogyosho) | The image was not transferred. (Scumming of non-image area) |
| 3. | Vinyl chloride/vinyl acetate copolymer (Kanegafuchi Chemical Industry Co.,Ltd) | The non-image area was transferred, but the image was not transferred. (Scumming of non-image area) |
| 4. | Polystyrene (Mitsubishi Monsant Chemical Company, number average molecular weight of 70000) | The image was not transferred. (No scumming of non-image area) |
| 5. | Polystyrene (DIC Elastyrene, Dainippon Ink and Chemicals Inc., number average molecular weight of 20000) | The non-image area was transferred, but the image was not transferred. (No scumming of non-image area) |

## Claims

1. A coloured image forming material comprising a transparent substrate having successively formed thereon a hot melt adhesive layer and a coloured image recording layer containing a photosensitive composition, characterised in that the hot melt adhesive layer contains a resin polymer having saturated alicyclic hydrocarbon groups.

2. A coloured image forming material according to claim 1 wherein the coloured image recording layer contains a polymer comprising structural units of formula (I)

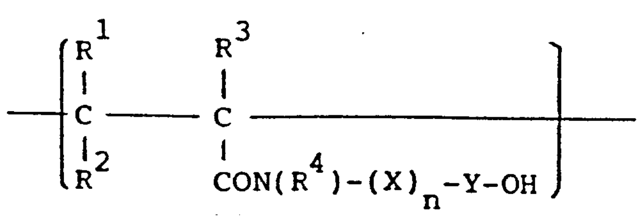

wherein:

$R^1$ and $R^2$ independently represent hydrogen, an alkyl group or a carboxylic acid group,

$R^3$ represents hydrogen, a halogen or an alkyl group,

$R^4$ represents hydrogen, an alkyl group, a phenyl group or an aralkyl group,

Y represents an optionally substituted phenylene group or an optionally substituted naphthylene group,

X represents a divalent organic group connected to a carbon atom of the aromatic ring of the Y group, and

n is 0 or 1.

3. A coloured image forming material according to claim 2 wherein the softening point of the polymer comprising structural units of formula (I) is from 50 °C to 150 °C.

4. A coloured image forming material according to claim 2 or 3 wherein the polymer comprising structural units of formula (I) also comprises units derived from acrylonitrile, alkyl acrylate, alkyl methacrylate,

acrylic acid or methacrylic acid.

**5.** A coloured image forming material according to any one of the preceding claims wherein the resin polymer having saturated alicyclic hydrocarbon groups has a weight average molecular weight of from 500 to 1000 and a softening point of from 70 °C to 120 °C.

**6.** A coloured image forming material according to any one of claims 1 to 5 wherein the coloured image recording layer contains a sufficient amount of a colouring agent and a polymer soluble in an alkaline aqueous solution such that the coloured image recording layer has an optical transmission density of at least 0.4.

**7.** A coloured image forming material according to any one of claims 1 to 6 wherein the surface of the substrate is first subjected to a release treatment before the hot melt adhesive layer is formed thereon.

**8.** A coloured image forming material according to any one of claims 1 to 7 wherein the coloured image recording layer is developable with an aqueous solution having a pH of from 8 to 11.

**9.** A method for forming a coloured image which comprises imagewise exposing a coloured image forming material as defined in any one of claims 1 to 8 to actinic radiation, developing the exposed material to form a coloured image and transferring the formed image onto a receptive surface of a receptive material.

**Patentansprüche**

**1.** Ein Farbbild-Darstellungsmaterial umfassend ein transparentes Substrat, auf dem nacheinander eine schmelzkleberschicht und eine farbige Bildaufzeichnungsschicht, die eine photosensitive Zusammensetzung enthält, ausgebildet sind, dadurch gekennzeichnet, daß die Schmelzkleberschicht ein Harzpolymer enthält, das gesättigte alicyclische Kohlenwasserstoffgruppen aufweist.

**2.** Farbbild-Darstellungsmaterial nach Anspruch 1, bei dem die farbige Bildaufzeichnungsschicht ein Polymer enthält, das Struktureinheiten der Formel (I) aufweist

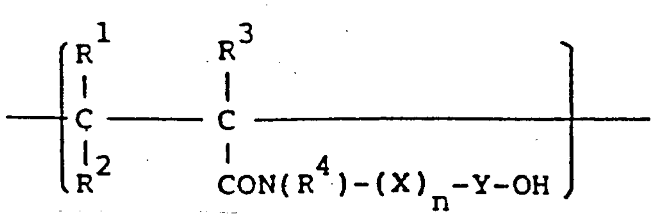

worin
$R^1$ und $R^2$ unabhängig ein Wasserstoff, eine Alkylgruppe oder eine Carbonsäuregruppe darstellen;
$R^3$ ein Wasserstoff, ein Halogen oder eine Alkylgruppe darstellt;
$R^4$ ein Wasserstoff, eine Alkylgruppe, eine Phenylgruppe oder eine Aralkylgruppe darstellt;
Y eine wahlweise substituierte Phenylengruppe oder eine wahlweise substituierte Naphthylengruppe darstellt;
X eine divalente organische Gruppe darstellt, die an ein Kohlenstoffatom des aromatischen Rings der Y-Gruppe gebunden ist, und
n gleich 0 oder 1 ist.

**3.** Farbbild-Darstellungsmaterial nach Anspruch 2, wobei die Erweichungstemperatur des Polymers, das die Struktureinheiten der Formel (I) enthält, zwischen 50 °C und 150 °C liegt.

**4.** Farbbild-Darstellungsmaterial nach Anspruch 2 oder 3, wobei das Polymer, das die Struktureinheiten der Formel (I) enthält, auch Einheiten umfaßt, die von Acrylnitril, Alkylacrylat, Alkylmethacrylat, Acrylsäure oder Methacrylsäure abgeleitet sind.

**5.** Farbbild-Darstellungsmaterial nach einem der vorangehenden Ansprüche, wobei das Harzpolymer, das gesättigte alicyclische Kohlenwasserstoffgruppen aufweist, ein Gewichtsmittel des Molekulargewichts von 500 bis 1000 und eine Erweichungstemperatur im Bereich von 70 °C bis 120 °C hat.

**6.** Ein Farbbild-Darstellungsmaterial nach einem der Ansprüche 1-5, wobei die farbige Bildaufzeichnungsschicht eine ausreichende Menge Farbmittel und ein Polymer, welches in einer alkalischen wäßrigen Lösung löslich ist, enthält, so daß die farbige Bildaufzeichnungsschicht eine optische Dichte von mindestens 0,4 hat.

**7.** Farbbild-Darstellungsmaterial nach einem der Ansprüche 1-6, wobei die Substratoberfläche zuerst einer Trennbehandlung unterworfen wird, bevor die Schmelzkleberschicht darauf ausgebildet wird.

**8.** Farbbild-Darstellungsmaterial nach einem der Ansprüche 1-7, wobei die farbige Bildaufzeichnungsschicht mit einer wäßrigen Lösung, die einen pH von 8 bis 11 hat, entwickelbar ist.

**9.** Verfahren zur Darstellung eines Farbbildes, welches ein bildweises Belichten eines Farbbild-Darstellungsmaterials, wie es in einem der Ansprüche 1 bis 8 definiert ist, mit photochemischer Strahlung, ein Entwickeln des belichteten Materials zur Darstellung eines Farbbildes sowie ein Übertragen des dargestellten Bildes auf eine aufnahmefähige Oberfläche eines aufnahmefähigen Materials enthält.

**Revendications**

**1.** Matériau générateur d'image colorée, comprenant un substrat transparent sur lequel sont successivement formées, une couche d'adhésif thermofusible et une couche d'enregistrement d'image colorée contenant une composition photosensible, caractérisé en ce que la couche d'adhésif thermofusible contient un polymère résineux comportant des groupes hydrocarbonés alicycliques saturés.

**2.** Matériau générateur d'image colorée selon la revendication 1, dans lequel la couche d'enregistrement d'image colorée, contient un polymère comprenant des motifs structuraux de formule (I) :

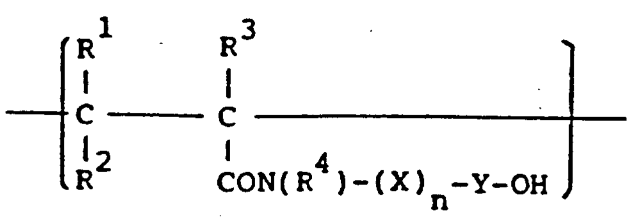

dans laquelle :
$R^1$ et $R^2$ représentent indépendamment chacun un atome d'hydrogène, un groupe alkyle ou acide carboxylique, $R^3$ représente un atome d'hydrogène, d'halogène ou un groupe alkyle ;
$R^4$ représente un atome d'hydrogène, un groupe alkyle, phényle ou aralkyle,
Y représente un groupe phénylène éventuellement substitué ou un groupe naphtylène éventuellement substitué,
X représente un groupe organique bivalent lié à un atome de carbone du cycle aromatique du groupe Y, et
n est égal à 0 ou 1.

**3.** Matériau générateur d'image colorée selon la revendication 2, dans lequel le point de ramollissement du polymère comprenant des motifs structuraux de formule (I), est de 50 °C à 150 °C.

**4.** Matériau générateur d'image colorée selon la revendication 2 ou 3, dans lequel le polymère comprenant des motifs structuraux de formule (I), comprend également des motifs dérivés d'acrylonitrile, d'acrylate d'alkyle, de méthacrylate d'alkyle, d'acide acrylique ou d'acide méthacrylique.

**5.** Matériau générateur d'image colorée selon l'une quelconque des revendications précédentes, dans lequel le polymère résineux comportant des groupes hydrocarbonés alicycliques saturés a un poids

moléculaire moyen en poids de 500 à 1 000, et un point de ramollissement de 70 °C à 120 °C.

6. Matériau générateur d'image colorée selon l'une quelconque des revendications 1 à 5, dans lequel la couche d'enregistrement d'image colorée contient une quantité suffisante d'un agent colorant et d'un polymère soluble dans une solution aqueuse alcaline, de telle façon que la couche d'enregistrement d'image colorée ait une densité de transmission optique d'au moins 0,4.

7. Matériau générateur d'image colorée selon l'une quelconque des revendications 1 à 6, dans lequel la surface du substrat est d'abord soumise à un traitement d'anti-adhérence avant de former sur celui-ci la couche d'adhésif thermofusible.

8. Matériau générateur d'image colorée selon l'une quelconque des revendications 1 à 7, dans lequel la couche d'enregistrement d'image colorée, est développable avec une solution aqueuse ayant un pH de 8 à 11.

9. Procédé de formation d'une image colorée, selon lequel on expose à un rayonnement actinique sous la forme d'une image, un matériau générateur d'image colorée selon l'une quelconque des revendications 1 à 8, on développe le matériau exposé pour former une image colorée, et on transfère l'image formée sur une surface réceptrice d'un matériau récepteur.

Fig.1

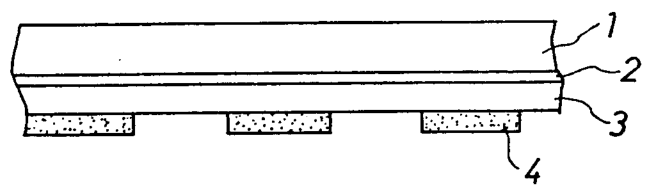


Fig.2